# EUROPEAN PATENT APPLICATION

(11) **EP 4 425 738 A1**
(43) Date of publication of application: **04.09.2024**
(21) Application number: 22946290.8
(22) Date of filing: 17.06.2022
(51) Int. Cl.: H02J 7/00, H01M 50/00, H01M 10/65

(54) **SAFETY CONTROL MECHANISM AND METHOD, BATTERY SYSTEM AND ELECTRIC DEVICE**

(71) Applicant: Contemporary Amperex Technology Co., Limited, Ningde, Fujian 352100 (CN)
(72) Inventor: CHEN, Xiaobo, Ningde, Fujian 352100 (CN); PU, Yujie, Ningde, Fujian 352100 (CN); LI, Yao, Ningde, Fujian 352100 (CN); KE, Jianhuang, Ningde, Fujian 352100 (CN); YANG, Piaopiao, Ningde, Fujian 352100 (CN)
(74) Representative: Gong, Jinping
(86) International application number: PCT/CN2022/099488
(87) International publication number: WO 2023/240604

(57) **Abstract**

Embodiments of the present application provide a safety control mechanism and method, a battery system, and an electrical apparatus, which are capable of improving the safety performance of a battery. The safety control mechanism is used for performing safety control on a battery. The safety control mechanism includes: a voltage generation module and a safety member; the voltage generation module is used for establishing a voltage difference between the safety member and the battery, and when the battery is abnormal, the voltage difference causing the safety member to perform safety control. Through the technical solution, in addition to the safety member, the safety control mechanism may further include the voltage generation module, which may be used for actively establishing the voltage difference between the safety member and the battery, and the actively established voltage difference is capable of being generated based on actual needs, and causing the safety member to perform safety control on the battery in time, so as to eliminate or prevent potential safety hazards in the battery, thereby performing timely and effective safety control on the battery to improve the safety performance of the battery.

## Description

### TECHNICAL FIELD

The present application relates to the field of battery technologies, and in particular, to a safety control mechanism and method, a battery system, and an electrical apparatus.

### BACKGROUND ART

With the continuous advancement of battery technologies, various new energy industries using batteries as energy storage devices have developed rapidly. In the development of the battery technologies, safety is also a non-negligible issue in addition to improvement of performance of the batteries. If the safety of the battery cannot be guaranteed, the battery cannot be used. Therefore, how to improve the safety performance of the batteries is an urgent technical problem to be solved in the battery technologies.

### SUMMARY OF THE INVENTION

The present application provides a safety control mechanism and method, a battery system, and an electrical apparatus, which are capable of improving the safety performance of a battery.

In the first aspect, a safety control mechanism is provided, which is used for performing safety control on a battery. The safety control mechanism includes: a voltage generation module and a safety member; the voltage generation module is used for establishing a voltage difference between the safety member and the battery, and when the battery is abnormal, the voltage difference causing the safety member to perform safety control.

Through the technical solution of the embodiment of the present application, in addition to the safety member, the safety control mechanism may further include the voltage generation module, which may be used for actively establishing the voltage difference between the safety member and the battery, and the actively established voltage difference is capable of being generated based on actual needs, and causing the safety member to perform safety control on the battery in time, so as to eliminate or prevent potential safety hazards in the battery, thereby performing timely and effective safety control on the battery to improve the safety performance of the battery.

In some possible embodiments, the safety member accommodates a safety substance; and the voltage difference causing the safety member to perform safety control includes: the voltage difference being used for forming an arc between the safety member and the battery to break down the safety member, so that the safety member releases the safety substance for performing safety control.

Through the technical solution of the embodiment, the safety member accommodates the safety substance, and when the battery is abnormal, the voltage difference actively established between the safety member and the battery by the voltage generation module is capable of actively forming the arc between the safety member and the battery. Through the arc with relatively large energy, the safety member can be more effectively and quickly broken down, thereby releasing the safety substance accommodated in the safety member to play a role in safety control of the battery, and further improving the safety performance of the battery.

In some possible embodiments, the battery includes a first battery cell; and the when the battery is abnormal, the voltage difference causing the safety member to perform safety control includes: when the first battery cell is abnormal, the voltage difference causing the safety member to perform safety control.

Through the technical solution of the embodiment, the voltage generation module can establish the voltage difference between the battery and the safety member, and when the first battery cell is abnormal, the safety member can be caused through the voltage difference to perform safety control on the battery. The technical solution is capable of performing safety control on the battery according to the abnormality of the first battery cell in the battery, so as to be capable of ensuring the safety performance of the battery more reliably and in a targeted manner.

In some possible embodiments, establishing a voltage difference between the safety member and the battery includes: establishing the voltage difference between the safety member and the first battery cell; and the voltage difference being used for forming an arc between the safety member and the battery to break down the safety member, so that the safety member releases the safety substance for performing safety control includes: the voltage difference being used for forming an arc between the safety member and the first battery cell to break down the safety member, so that the safety member releases the safety substance for performing safety control on the space where the first battery cell is located and/or the space near the first battery cell.

Through the technical solution of the embodiment, the arc actively formed by the voltage generation module between the first battery cell and the safety member can cause the safety substance in the safety member to precisely and reliably control the space where the first battery cell is located and/or the space near first battery cell, thereby preventing heat generated by the first battery cell in an abnormal state from spreading and transferring to other parts of the battery, and effectively ensuring the safety performance of the battery.

In some possible embodiments, the voltage difference is used for forming the arc between the safety member and the first battery cell to break down the safety member and a case of the first battery cell, so that the safety member releases the safety substance to perform safety control on the internal space of the first battery cell.

Through the technical solution of the embodiment, the arc formed between the safety member and the first battery cell can not only break down and destroy a container wall of the safety member, but also break down and destroy the case of the first battery cell. When the first battery cell is abnormal and its internal temperature is high, the arc destroys the case of the first battery cell, which can facilitate the safety substance released from the safety member to accurately and efficiently reduce the temperature of the interior of the first battery cell, thereby preventing the heat generated by the first battery cell in the abnormal state from spreading to other battery cells, and further improving the safety performance of the battery.

In some possible embodiments, the voltage difference is related to at least one of the following parameters: the wall thickness of the safety member, the distance between the safety member and the first battery cell, and the corresponding area between the safety member and the first battery cell.

Through the technical solution of the embodiments of the present application, when designing the voltage difference between the safety member and the first battery cell, relevant parameters of the safety member, the first battery cell, and an environment in which they are located may be comprehensively considered to obtain a more suitable voltage difference, thereby generating a more stable and controllable arc.

In some possible embodiments, the voltage difference and the wall thickness of the safety member meet the following relationship: 1≤U/T≤5000, wherein U is the voltage difference in V, and T is the wall thickness of the safety member in mm; and/or the voltage difference and the distance between the safety member and the first battery cell meet the following relationship: U/d>2, wherein U is the voltage difference in V, and d is the distance between the safety member and the first battery cell in mm; and/or, the voltage difference and the corresponding area between the safety member and the first battery cell meet the following relationship: U/S>0.00008, where U is the voltage difference in V, and S is the corresponding area between the safety member and the first battery cell in mm².

Through the technical solution of the embodiment of the present application, by using the correlation between the voltage difference and the at least one parameter, the voltage difference required to generate the arc can be obtained more conveniently and more accurately, so as to ensure the safety performance of the battery.

In some possible embodiments, the voltage difference ranges from 4 V to 1000 V.

Through the technical solution of the embodiment, the voltage difference is controlled within the range of 4 V to 1000 V or a more precise voltage difference range, the voltage difference can form the arc between the safety member and the first battery cell, and the arc can break down the container wall of the safety member to release the safety substance, thereby comprehensively ensuring the safety performance of the battery.

In some possible embodiments, the first battery cell and the safety member are insulated from each other. When the first battery cell is abnormal, the insulation between the first battery cell and the safety member fails, and the voltage difference between the first battery cell and the safety member causes the safety member to perform safety control.

Through the technical solution of the embodiment, in the battery, the mutual insulation between the first battery cell and the safety member can ensure that the safety member has little impact on the first battery cell and ensure the safety performance of the first battery cell in a normal operating state. On this basis, the abnormality of the first battery cell may cause an insulation failure between it and the safety member, and then the safety member is caused to perform safety control on the battery where the first battery cell is located. The overall embodiment has a high degree of pertinence and reliability.

In some possible embodiments, when the first battery cell is abnormal, the state of an insulation layer between the first battery cell and the safety member changes, so that the insulation between the first battery cell and the safety member fails.

In the technical solution of the embodiment, the insulation design of the insulation layer between the first battery cell and the safety member is easy to be implemented in the battery and is capable of ensuring the insulation performance. Further, the insulation layer is capable of responding to an abnormal state such as thermal runaway of the first battery cell, so that an effective insulation failure is formed between the first battery cell and the safety member, and the safety member is caused to perform safety control on the battery where the first battery cell is located, thereby preventing or eliminating the safety impact of the heat generated by the first battery cell on the battery.

In some possible embodiments, the safety member is arranged corresponding to the first battery cell.

Through the technical solution of the embodiment, the safety member is arranged corresponding to the first battery cell in at least one battery cell, but not corresponding to other battery cells, which can prevent the safety member from affecting other battery cells, thereby ensuring the operating performance of the other normal battery cells in the battery.

In some possible embodiments, the voltage generation module is used for acquiring a characteristic signal of the battery, the characteristic signal of the battery being used for indicating that the battery is abnormal; and the voltage generation module is used for establishing the voltage difference between the safety member and the battery according to the characteristic signal of the battery.

Through the technical solution of the embodiment, the voltage generation module is capable of acquiring the characteristic signal used for indicating the abnormality of the battery, and establishing the voltage difference between the safety member and the battery according to the characteristic signal, so that the voltage generation module is caused to be capable of performing relatively reliable safety control on the battery in an abnormal state in time.

In some possible embodiments, the voltage generation module includes: a control sub-module and a voltage sub-module; the control sub-module is used for acquiring the characteristic signal of the battery, and controlling, according to the characteristic signal of the battery, the voltage sub-module to establish the voltage difference between the safety member and the battery.

Through the technical solution of the embodiment, a control sub-module is arranged in the voltage generation module, and the control sub-module is capable of flexibly controlling the voltage sub-module to establish the voltage difference between the safety member and the battery. Compared with the technical solution in which the voltage generation module continuously establishes the voltage difference between the safety member and the battery, the technical solution can reduce the impact of the continuous voltage difference between the safety member and the battery on the safety performance of the battery, and further improve the safety management performance the safety control mechanism on the battery.

In some possible embodiments, the voltage generation module further includes: a monitoring sub-module; the monitoring sub-module is used for monitoring the characteristic signal of the battery and sending the characteristic signal of the battery to the control sub-module.

Through the technical solution of the embodiment, the independent monitoring sub-module is arranged in the safety control mechanism, which can be used for actively monitoring the characteristic signal of the battery in real time, so that the safety control mechanism is caused to perform a more timely and effective safety management on the battery, thereby further improving the safety performance of the battery.

In some possible embodiments, the voltage sub-module includes: a voltage generator and an on-off structure, the voltage generator being connected to the safety member through the on-off structure; and the control sub-module is used for controlling, according to the characteristic signal of the battery, the on-off structure to be turned on, so as to cause the voltage generator to establish the voltage difference between the safety member and the battery.

Through the technical solution of the embodiment, the voltage sub-module includes the voltage generator and the on-off structure, and the on-off structure is capable of realizing the connection between the safety member and the voltage generator under the control of the control sub-module. The overall solution is simple in implementation and high in reliability, and will not bring too much extra cost to the safety control mechanism.

In some possible embodiments, the voltage generator includes: a second battery cell in the battery.

Through the technical solution of the embodiment, the second battery cell in the battery is reused as the voltage generator, and there is no need to add an additional voltage generator in the system where the battery is located, thereby saving the space occupied by the safety control mechanism in the system where the battery is located, which is beneficial to reduce the overall volume of the system where the battery is located and the cost required for production.

In some possible embodiments, the characteristic signal of the battery is used for indicating that the battery is in a thermal runaway state and/or in a critical state within a preset time period before the thermal runaway state.

Through the technical solution of the embodiment, the characteristic signal of the battery is capable of being used for indicating the thermal runaway state and/or the critical state of thermal runaway that are common in the battery and cause great damage to the battery. Through the characteristic signal of the battery, the battery is capable of effectively controlling the thermal runaway state and/or the critical state to ensure the safety performance of the battery.

In some possible embodiments, the characteristic signal of the battery includes at least one of the following signals: electrical parameter, temperature, pressure, characteristic gas, or stress.

Through the technical solution of the embodiment, the electrical parameter, temperature, pressure, characteristic gas or stress, and other signals are easy to detect and are capable of effectively reflecting the operating state of the battery. According to the at least one signal, it is capable of effectively judging that the battery is in an abnormal state, thereby facilitating the safety control mechanism to perform safety control on the battery in the abnormal state.

In some possible embodiment manners, the characteristic signal of the battery includes: a characteristic signal of the first battery cell in the battery; and the voltage generation module is used for establishing, according to the characteristic signal of the first battery cell, the voltage difference between the safety member and the first battery cell.

Through the technical solution of the embodiment, the voltage generation module is capable of accurately and timely forming the voltage difference between the safety member and the first battery cell according to the characteristic signal of the first battery cell, so that the safety member is capable of quickly performing precise safety control on the first battery cell. Further, when the characteristic signal of the first battery cell is used for indicating that the first battery cell is in the thermal runaway state and/or in the critical state within the preset time period before the thermal runaway state, the voltage generation module and the safety member in the safety control mechanism cooperate with each other to perform fire-fighting on the first battery cell in the thermal runaway state and/or the critical state in time or even in advance, thereby preventing internal heat of the first battery cell from spreading in the battery and affecting the performance of other battery cells, quickly performing safety control on the battery where the first battery cell is located, and thus being capable of greatly improving the safety performance of the battery.

In the second aspect, a safety control method is provided, which is used for performing safety control on a battery. The safety control method includes: establishing a voltage difference between a safety member and the battery; and when the battery is abnormal, the voltage difference causing the safety member to perform safety control.

In some possible embodiments, the safety member accommodates a safety substance; and the voltage difference causing the safety member to perform safety control includes: the voltage difference being used for forming an arc between the safety member and the battery to break down the safety member, so that the safety member releases the safety substance for performing safety control.

In some possible embodiments, the battery includes a first battery cell; and the when the battery is abnormal, the voltage difference causing the safety member to perform safety control includes: when the first battery cell is abnormal, the voltage difference causing the safety member to perform safety control.

In some possible embodiments, the establishing a voltage difference between the safety member and the battery includes: establishing the voltage difference between the safety member and the first battery cell; and the voltage difference being used for forming an arc between the safety member and the battery to break down the safety member, so that the safety member releases the safety substance for performing safety control includes: the voltage difference being used for forming an arc between the safety member and the first battery cell to break down the safety member, so that the safety member releases the safety substance for performing safety control on the space where the first battery cell is located and/or the space near the first battery cell.

In some possible embodiments, the voltage difference being used for forming an arc between the safety member and the first battery cell to break down the safety member, so that the safety member releases the safety substance for performing safety control on the space where the first battery cell is located includes: the voltage difference being used for forming the arc between the safety member and the first battery cell to break down the safety member and a case of the first battery cell, so that the safety member releases the safety substance for performing safety control on the internal space of the first battery cell.

In some possible embodiments, the voltage difference is related to at least one of the following parameters: the wall thickness of the safety member, the distance between the safety member and the first battery cell, and the corresponding area between the safety member and the first battery cell.

In some possible embodiments, the voltage difference and the wall thickness of the safety member meet the following relationship: 1≤U/T≤5000, wherein U is the voltage difference in V, and T is the wall thickness of the safety member in mm; and/or the voltage difference and the distance between the safety member and the first battery cell meet the following relationship: U/d>2, wherein U is the voltage difference in V, and d is the distance between the safety member and the first battery cell in mm; and/or, the voltage difference and the corresponding area between the safety member and the first battery cell meet the following relationship: U/S>0.00008, where U is the voltage difference in V, and S is the corresponding area between the safety member and the first battery cell in mm².

In some possible embodiments, the voltage difference ranges from 4 V to 1000 V.

In some possible embodiments, the first battery cell and the safety member are insulated from each other. When the first battery cell is abnormal, the insulation between the first battery cell and the safety member fails, and the voltage difference between the first battery cell and the safety member causes the safety member to perform safety control.

In some possible embodiments, when the first battery cell is abnormal, the state of an insulation layer between the first battery cell and the safety member changes, so that the insulation between the first battery cell and the safety member fails.

In some possible embodiments, the safety member is arranged corresponding to the first battery cell in at least one battery cell.

In some possible embodiments, the establishing a voltage difference between the safety member and battery includes: acquiring a characteristic signal of the battery, the characteristic signal of the battery being used for indicating that the battery is abnormal; and establishing the voltage difference between the safety member and the battery according to the characteristic signal of the battery.

In some possible embodiments, the safety control method is applied to the voltage generation module, and the voltage generation module includes: a control sub-module and a voltage sub-module; wherein the acquiring a characteristic signal of the battery includes: acquiring the characteristic signal of the battery by the control sub-module; and the establishing a voltage difference between the safety member and the battery according to the characteristic signal of the battery includes: controlling, by the control sub-module according to the characteristic signal of the battery, the voltage sub-module to establish the voltage difference between the safety member and the battery.

In some possible embodiments, the voltage generation module further includes: a monitoring sub-module; and the safety control method further includes: monitoring, by the monitoring sub-module, the characteristic signal of the battery and sending the characteristic signal of the battery to the control sub-module.

In some possible embodiments, the voltage sub-module includes: a voltage generator and an on-off structure, the voltage generator being connected to the safety member through the on-off structure; wherein the controlling, by the control sub-module according to the characteristic signal of the battery, the voltage sub-module to establish the voltage difference between the safety member and the battery includes: controlling, by the control sub-module according to the characteristic signal of the battery, the on-off structure to be turned on, so as to cause the voltage generator to establish the voltage difference between the safety member and the battery.

In some possible embodiments, the voltage generator includes: a second battery cell in the battery.

In some possible embodiments, the characteristic signal of the battery is used for indicating that the battery is in a thermal runaway state and/or in a critical state within a preset time period before the thermal runaway state.

In some possible embodiments, the characteristic signal of the battery includes at least one of the following signals: electrical parameter, temperature, pressure, characteristic gas, or stress.

In some possible embodiment manners, the characteristic signal of the battery includes: a characteristic signal of the first battery cell in the battery; wherein the acquiring a characteristic signal of the battery includes: acquiring a characteristic signal of the first battery cell, and the establishing the voltage difference between the safety member and the battery according to the characteristic signal of the battery includes: establishing, according to the characteristic signal of the first battery cell, the voltage difference between the safety member and the first battery cell.

In the third aspect, a battery system is provided, including: a battery, and the safety control mechanism in the first aspect or any possible embodiment of the first aspect, wherein the safety control mechanism is used for performing safety control on a battery.

In the fourth aspect, an electrical apparatus is provided, including the battery system in the third aspect, the battery system being used for providing electric energy to the electrical apparatus.

Through the technical solution of the embodiment of the present application, in addition to the safety member, the safety control mechanism may further include the voltage generation module, which may be used for actively establishing the voltage difference between the safety member and the battery, and the actively established voltage difference is capable of being generated based on actual needs, and causing the safety member to perform safety control on the battery in time, so as to eliminate or prevent potential safety hazards in the battery, thereby performing timely and effective safety control on the battery to improve the safety performance of the battery.

### DESCRIPTION OF DRAWINGS

In order to explain technical solutions of embodiments of the present application more clearly, a brief introduction of drawings to be used in the embodiments of the present application will be made below. Apparently, the drawings described below are merely some embodiments of the present application, and other drawings can be obtained according to these drawings by those of ordinary skill in the art without creative efforts.
Fig. 1 is a schematic structural diagram of a vehicle according to an embodiment of the present application;
Fig. 2 is a schematic structural diagram of a battery according to an embodiment of the present application;
Fig. 3 is a schematic structural block diagram of a safety control mechanism according to an embodiment of the present application;
Fig. 4 is another schematic structural block diagram of a safety control mechanism according to an embodiment of the present application;
Fig. 5 is another schematic structural block diagram of a safety control mechanism according to an embodiment of the present application;
Fig. 6 is another schematic structural block diagram of a safety control mechanism according to an embodiment of the present application;
Fig. 7 is another schematic structural block diagram of a safety control mechanism according to an embodiment of the present application;
Fig. 8 is another schematic structural block diagram of a safety control mechanism according to an embodiment of the present application;
Fig. 9 is another schematic structural block diagram of a safety control mechanism according to an embodiment of the present application;
Fig. 10 is another schematic structural block diagram of a safety control mechanism according to an embodiment of the present application;
Fig. 11 is another schematic structural block diagram of a safety control mechanism according to an embodiment of the present application;
Fig. 12 is another schematic structural block diagram of a safety control mechanism according to an embodiment of the present application;
Fig. 13 is a schematic flow chart of a safety control method according to an embodiment of the present application;
Fig. 14 is a schematic flow chart of another safety control method according to an embodiment of the present application;
Fig. 15 is a schematic flow chart of another safety control method according to an embodiment of the present application; and
Fig. 16 is a schematic structural block diagram of a battery system according to an embodiment of the present application.

In the drawings, the drawings are not drawn to actual scale.

### DETAILED DESCRIPTION

In order to make objectives, technical solutions and advantages of the embodiments of the present invention clearer, the technical solutions in embodiments of the present application will be described clearly through the accompanying drawings in the embodiments of the present application the described embodiments are a part of embodiments of the present application, and are not all the embodiments. Based on the embodiments of the present application, all other embodiments derived by a person of ordinary skill in the art without any creative effort shall all fall within the protection scope of the present application.

Unless otherwise defined, all technical and scientific terms used herein have the same meaning as commonly understood by those skilled in the art to which the present application belongs. The terms used herein are for the purpose of describing specific embodiments only, and are not intended to limit the present application. The terms "include/comprise" and "have" and any variations thereof in the specification and claims of the present application as well as in the above description of drawings are intended to cover a non-exclusive inclusion. Terms such as "first" and "second" in the specification, the claims, and the accompanying drawings of the present application are used for distinguishing similar objects, and are not intended to describe a specific sequence or primary and secondary relations.

Reference herein to "an embodiment" means that a particular feature, structure, or characteristic described in connection with the embodiment can be included in at least one embodiment of the present application. The appearance of this phrase in various places in the specification does not necessarily refer to the same embodiment, nor is it a separate or alternative embodiment that is mutually exclusive with other embodiments. It is understood explicitly and implicitly by those skilled in the art that the embodiments described in the present application can be combined with other embodiments.

In the description of the present application, it should be noted that the terms "mounting", "connecting", "connection" and "attachment" should be understood in a broad sense, unless otherwise explicitly specified or defined. For example, it may be a fixed connection, a detachable connection, or an integrated connection; and it may be a direct connection or an indirect connection through an intermediate medium, or may be a communication between the interior of two elements. For those of ordinary skill in the art, the specific meanings of the above terms in the present application can be understood according to specific situations.

In the present application, the term "and/or" is only an association relationship for describing associated objects, indicating that three relationships may exist. For example, A and/or B may represent three situations: A exists alone, both A and B exist, and B exists alone. In addition, the character "/" in the present application generally means that the associated objects before and after it are in an "or" relationship.

Reference herein to "an embodiment" means that a particular feature, structure, or characteristic described in connection with the embodiment can be included in at least one embodiment of the present application. The appearance of this phrase in various places in the specification does not necessarily refer to the same embodiment, nor is it a separate or alternative embodiment that is mutually exclusive with other embodiments. It is understood explicitly and implicitly by those skilled in the art that the embodiments described in the present application can be combined with other embodiments.

In the present application, a battery refers to a physical module that includes one or a plurality of battery cells to provide electrical energy. For example, the battery mentioned in the present application may include a battery module, a battery pack, or the like. The battery generally includes a box body for encapsulating one or a plurality of battery cells. The box body can prevent liquid or other foreign matters from affecting charging or discharging of the battery cells.

Optionally, the battery cell may be a chemical battery or a physical battery. As an example, it may be a lithium-ion secondary battery, a lithium-ion primary battery, a lithium-sulfur battery, a sodium/lithium-ion battery, a sodium-ion battery, a magnesium-ion battery, or the like, which is not limited in the embodiments of the present application. The battery cells may be cylindrical, flat, rectangular, or in other shapes, which is not limited in the embodiments of the present application. The battery cells are generally classified into three types according to encapsulating manners: cylindrical battery cells, rectangular battery cells, and pouch cells, which are not limited in the embodiments of the present application.

The battery cell includes an electrode assembly and an electrolyte solution, the electrode assembly being composed of a positive electrode plate, a negative electrode plate, and a separator. The battery cell operates mainly relying on movement of metal ions between the positive electrode plate and the negative electrode plate. The positive electrode plate includes a positive electrode current collector and a positive electrode active material layer. A surface of the positive electrode current collector is coated with the positive electrode active material layer. Current collectors not coated with the positive electrode active material layer protrude from the current collector coated with the positive electrode active material layer. The current collectors not coated with the positive electrode active material layer are used as positive tabs. Optionally, there are a plurality of positive tabs which are stacked together, and there are a plurality of negative tabs which are stacked together. A diaphragm may be made of polypropylene (PP), polyethylene (PE), or the like. In addition, the electrode assembly may be of a wound structure or a laminated structure, which is not limited in the embodiments of the present application.

Design factors in many aspects, for example, performance parameters such as energy density, cycle life, discharge capacity, and charging and discharging rates, should be considered in the development of the battery technologies. In addition, the safety of the battery also needs to be considered.

In some related technologies, in order to ensure the safety of the battery, the battery cell is generally provided with a pressure relief mechanism. The pressure relief mechanism refers to an element or component that is actuated to relieve the internal pressure or temperature when the internal pressure or temperature of the battery cell reaches a predetermined threshold. The pressure relief mechanism may adopt an element or component that is sensitive to pressure or temperature. That is, when thermal runaway occurs in the battery cell and its internal pressure or temperature reaches a predetermined threshold, the pressure relief mechanism is actuated to form a channel for relieving the internal pressure or temperature. After the pressure relief mechanism is activated, high-temperature and high-pressure substances inside the battery cell will be discharged from the pressure relief mechanism as emissions. The emissions in the battery cell include, but are not limited to, the electrolyte solution, dissolved or split positive and negative electrode plates, fragments of the separator, high-temperature and high-pressure gases produced by reactions, flames, and the like.

For example, when a short circuit, overcharge, or the like occurs in the battery cell, it may cause thermal runaway inside the battery cell, resulting in a sudden rise in pressure or temperature. In this case, the internal pressure and temperature can be relieved outward through the actuation of the pressure relief mechanism to prevent explosion and fire of the battery cell, thereby ensuring the safety performance of the battery cell.

In addition to arranging the pressure relief mechanism on the battery cell to ensure the safety of the battery, fire-fighting components such as a spray pipe may further be arranged in the box body of the battery cell. The spray pipe may accommodate a fire-fighting medium, and the fire-fighting medium may be a fire-fighting liquid, a fire-fighting gas, or a fire-fighting solid. Optionally, in some embodiments, the spray pipe can be arranged corresponding to the pressure relief mechanism in the battery cell. When the pressure relief mechanism is actuated, the emissions discharged from the battery cell may destroy the wall of the spray pipe, so that the fire-fighting medium flows out from the spray pipe, and the fire-fighting medium can cool the high-temperature emissions of the battery cell and reduce the danger of the emissions, thereby improving the safety performance of the battery cell and the overall battery.

In this technical solution, when thermal runaway has occurred inside the battery cell, the spray pipe can be passively damaged by the emissions inside the battery cell, and then the temperature of the battery cell that has experienced thermal runaway can be realized. When thermal runaway has occurred inside the battery cell, the temperature of the battery cell is relatively high, and the heat generated by it may have been transferred to a plurality of adjacent battery cells, so that the heat has been spread to a plurality of battery cells in the battery. At this time, even if the spray pipe can cool the battery cell that has experienced thermal runaway, the cooling effect may be relatively limited, and the safety control performance of the spray pipe for the overall battery is relatively poor. In addition, when batteries with different capacities or different energy densities are out of control, temperatures of the emissions discharged from pressure relief mechanisms thereof are significantly different, the degrees of damage to the spray pipes are different, and the effects of the liquids flowing out from the spray pipes are also different. Therefore, the fire-fighting effect generated by the passive destruction of the spray pipe is unstable.

In view of this, the present application provides a safety control mechanism for performing safety control on a battery. The safety control mechanism includes: a voltage generation module and a safety member. The voltage generation module is used for establishing a voltage difference between the safety member and the battery, and when the battery is abnormal, the voltage difference causing the safety member to perform safety control on the battery. In the technical solution according to the embodiments of the present application, in addition to the safety member, the safety control mechanism may further include the voltage generation module, which may be used for actively establishing the voltage difference between the safety member and the battery, and the actively established voltage difference is capable of being generated based on actual needs, and causing the safety member to perform safety control on the battery in time, so as to eliminate or prevent potential safety hazards in the battery, thereby performing timely and effective safety control on the battery to improve the safety performance of the battery.

The technical solutions described in the embodiments of the present application are applicable to various apparatuses using batteries, such as portable electrical devices, battery vehicles, electric toys, electric tools, electric vehicles, ships, spacecrafts, energy storage systems, and the like. For example, the spacecrafts include airplanes, rockets, space shuttles, spaceships, and the like.

It should be understood that the technical solutions described in the examples of the present application are not only applicable to the apparatuses described above, but also applicable to all apparatuses using batteries. However, for the sake of brevity, the following embodiments are described by taking an electric vehicle as an example.

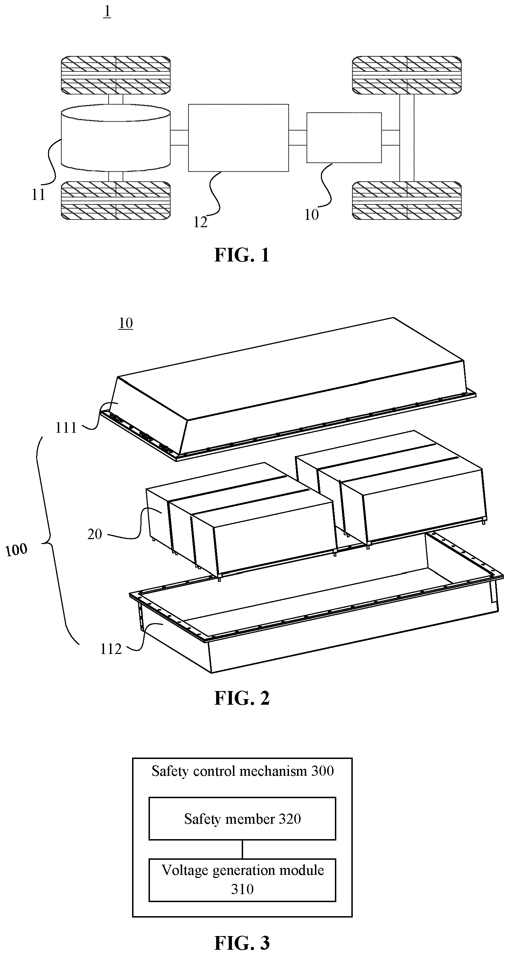

For example, as shown in Fig. 1, a schematic structural diagram of a vehicle 1 according to an embodiment of the present application is shown. The vehicle 1 may be a fuel vehicle, a gas vehicle, or a new energy vehicle, and the new energy vehicle may be an all-electric vehicle, a hybrid electric vehicle, an extended range electric vehicle, or the like. A motor 11, a controller 12, and a battery 10 may be arranged inside the vehicle 1, and the controller 12 is used for controlling the battery 10 to supply power to the motor 11. For example, the battery 10 may be arranged at the bottom or the head or the tail of the vehicle 1. The battery 10 may be used for supplying power to the vehicle 1, for example, the battery 10 may be used as an operating power source of the vehicle 1, which is used for a circuit system of the vehicle 1, for example, for operation power requirements of the vehicle 1 during starting, navigation, and running. In another example of the present application, the battery 10 can not only be used as the operating power source of the vehicle 1, but also can be used as a driving power source of the vehicle 1 to provide driving power for the vehicle 1 instead of or partially instead of fuel or natural gas.

In order to meet different power requirements, the battery 10 may include a plurality of battery cells, wherein the plurality of battery cells may be in series connection, in parallel connection, or in parallel-series connection, and the parallel-series connection refers to mixing of the series connection and the parallel connection. The battery 10 may also be referred to as a battery pack. In some embodiments, the plurality of battery cells may be in series, parallel, or series-parallel connection to form battery modules first, and then the plurality of battery modules may be in series, parallel, or parallel-series connection to form the battery 10. In other words, the plurality of battery cells may directly form the battery 10, or may form battery modules first, and then the battery modules form the battery 10.

For example, as shown in Fig. 2, which is a schematic structural diagram of a battery 10 according to an embodiment of the present application. The battery 10 may include a plurality of battery cells 20. The battery 10 may further include a box body 100 (or referred to as a cover body), the interior of the box body 100 is of a hollow structure, and the plurality of battery cells 20 may be accommodated in the box body 100. As shown in Fig. 2, the box body 100 may include two parts, which are referred to as a first part 111 and a second part 112 respectively, and the first part 111 and the second part 112 are snap-fitted together. The shapes of the first part 111 and the second part 112 may be determined according to the combined shape of the plurality of battery cells 20, and both the first part 111 and the second part 112 may have an opening. For example, both the first part 111 and the second part 112 may be hollow cuboids and each have only one surface being an opening surface. The opening of the first part 111 and the opening of the second part 112 are arranged opposite to each other, and the first part 111 and the second part 112 are snap-fitted together to form the box body 100 having a closed cavity. The plurality of battery cells 20 are assembled in parallel connection, in series connection, or in parallel-series connection, and then placed in the box body 100 formed by snap-fitting the first part 111 with the second part 112 together.

Optionally, the battery 10 may further include other structures, which will not be repeated here. For example, the battery 10 may further include a busbar component, and the busbar component is used for implementing electrical connections between the plurality of battery cells 20, for example, parallel connection, series connection, or parallel-series connection. Specifically, the busbar component may realize the electrical connections between the battery cells 20 by connecting electrode terminals of the battery cells 20. Further, the busbar component may be fixed to the electrode terminals of the battery cells 20 by welding. Electric energy of the plurality of battery cells 20 may be further led out through an electrically conductive mechanism penetrating the box body. Optionally, the electrically conductive mechanism may also belong to the busbar component.

Depending on different power requirements, the quantity of the battery cells 20 may be set to any value. The plurality of battery cells 20 may be in series connection, parallel connection, or parallel-series connection to achieve a larger capacity or power. Since the quantity of battery cells 20 included in each battery 10 may be large, for the convenience of mounting, the battery cells 20 may be arranged in groups, and each group of battery cells 20 constitutes a battery module. The quantity of the battery cells 20 included in the battery module is not limited, and may be set according to requirements.

Fig. 3 shows a schematic structural block diagram of a safety control mechanism 300 according to an embodiment of the present application. Specifically, the safety control mechanism 300 is used for performing safety control on a battery, for example, the safety control mechanism 300 can perform safety control on the battery 10 shown in Fig. 1 and Fig. 2.

As shown in Fig. 3, the safety control mechanism 300 includes: a voltage generation module 310 and a safety member 320. The voltage generation module 310 is used for establishing a voltage difference between the safety member 320 and the battery 10 (not shown in Fig. 3), and when the battery 10 is abnormal, the voltage difference causes the safety member 320 to perform safety control on the battery 10.

Specifically, in the embodiment of the present application, the voltage generation module 310 may be a module capable of forming a target voltage, for example, the voltage generation module 310 may include a power supply, a voltage generating circuit, or another module carrying electric energy. As an example, the voltage generation module 310 may include any battery cell 20 in the battery 10, that is, in this example, in addition to providing electric energy for an electrical apparatus outside the battery 10, the battery cell 20 in the battery 10 can also be reused as the voltage generation module 310 in the embodiment of the present application. As another example, the voltage generation module 310 may also be another electrical module independent of the battery 10, and the embodiment of the present application does not limit the specific embodiment of the voltage generation module 310.

The safety member 320 is a component used for eliminating hidden dangers or preventing disasters. Specifically, the safety member 320 may be used to for eliminating or preventing hidden dangers or disasters that may occur in the battery 10. As an example, the safety member 320 includes, but is not limited to, a fire-fighting component for realizing a fire-fighting function. The fire-fighting component accommodates a fire-fighting medium, and the fire-fighting medium is capable of performing fire-fighting on the battery cell 20 and/or another component that is about to experience thermal runaway or has experienced thermal runaway in the battery 10. Of course, in other examples, the safety member 320 may also be a component in other forms, which only needs to be capable of realizing the safety control function, and the specific embodiment is not limited in the embodiments of the present application.

Specifically, the voltage generation module 310 is used for establishing a voltage difference between the safety member 320 and the battery 10, and when the battery 10 is abnormal, the voltage difference can drive the safety member 320 or the voltage difference causes the safety member 320 to actuate, so that the safety member 320 performs safety control on the battery 10 to eliminate or prevent potential safety hazards in the battery 10.

Optionally, the voltage generation module 310 may be used for establishing the voltage difference between the safety member 320 and any component of the battery 10. When any component in the battery 10 is abnormal, the voltage difference may cause the safety member 320 to perform safety control on any component in the battery 10.

It should be noted that whether the battery or component is abnormal should adopt the normal understanding of those skilled in the art. For example, when an operating state of the battery or component does not belong to a normal state and/or does not belong to a preset state, it may be understood that the battery or the component is abnormal. For another example, when a parameter of the battery or component does not belong to a normal range and/or does not belong to a preset range, it may be understood that the battery or component is abnormal. As an example, when the operating state of the battery 10 is different from the normal state, it may be considered as that the battery 10 is abnormal, wherein when the battery 10 is in the normal state, various operating parameters of the battery 10 are within the preset normal parameter range. When the battery 10 is in an abnormal state, at least one operating parameter of the battery 10 may exceed the preset normal parameter range, and according to the at least one abnormal operating parameter, it may be determined that the battery 10 is abnormal. As an example, when the battery 10 is in a thermal runaway state or is in a temporary state where a thermal runaway state is about to occur, at least one operating parameter such as temperature, electrical parameter, and stress of the battery 10 may exceed the normal parameter range, and at this time, it may be determined that the battery 10 is in an abnormal state.

It should be further noted that when the battery 10 is in the normal operating state, the voltage difference established by the voltage generation module 310 between the safety member 320 and the battery 10 will not affect the battery 10, and only when the battery 10 is abnormal, may the voltage difference established by the voltage generation module 310 between the safety member 320 and the battery 10 drive the safety member 320 or the voltage difference cause the safety member 320 to actuate, so that the safety member 320 performs safety control on the battery 10 to eliminate or prevent safety hazards in the battery 10.

In view of the above, through the technical solution of the embodiment of the present application, in addition to the safety member 320, the safety control mechanism may further include the voltage generation module 310, which may be used for actively establishing the voltage difference between the safety member 320 and the battery 10, and the actively established voltage difference is capable of being generated based on actual needs, and causing the safety member 320 to perform safety control on the battery 10 in time, so as to eliminate or prevent potential safety hazards in the battery 10, thereby performing timely and effective safety control on the battery 10 to improve the safety performance of the battery 10.

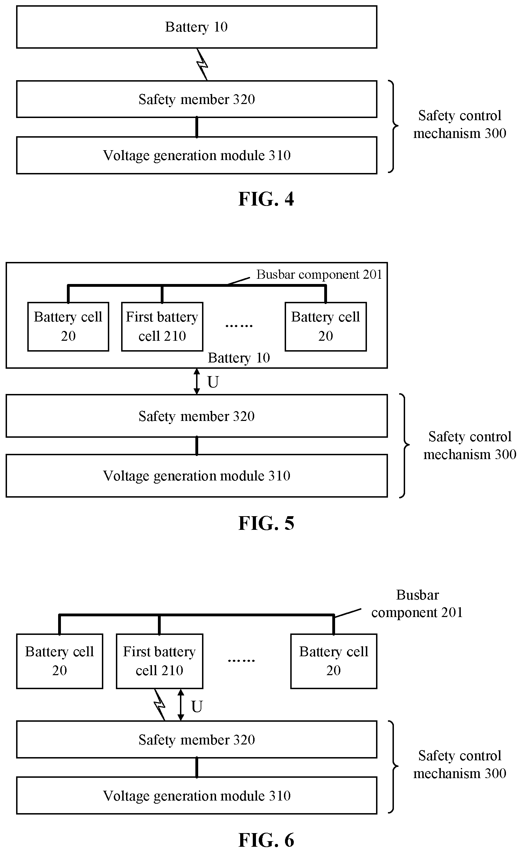

Fig. 4 shows another schematic structural block diagram of a safety control mechanism 300 according to an embodiment of the present application.

As shown in Fig. 4, in the embodiment of the present application, the safety member 320 accommodates a safety substance, and the voltage difference established by the voltage generation module 310 between the safety member 320 and the battery 10 is used for forming an arc between the safety member 320 and the battery 10 to break down the safety member 320, so that the safety member 320 releases the safety substance for performing safety control.

Specifically, the safety substance accommodated in the safety member 320 may be a substance used for implementing safety control on the battery 10. As an example, the safety substance may be a fluid with a certain fluidity, which can transfer and exchange heat generated in the battery 10 to realize safety control on the battery 10. The safety substance may be a liquid fluid or a gaseous fluid, for example, the fluid includes but is not limited to water, a mixture of water and ethylene glycol, or air. Alternatively, as another example, the safety substance may also implement safety control on the battery 10 through chemical reaction or other methods, which is not specifically limited in the embodiment of the present application.

Optionally, the safety member 320 accommodating the safety substance may be a tubular container, a plate container, or any other container of any shape. In some related embodiments, the safety member 320 may also be referred to as a fire-fighting pipe, a cooling plate, and another component for performing thermal management on at least one battery cell 20. Alternatively, in some other embodiments, the safety member 320 may also be a component dedicated to performing safety control on the battery 10.

When the battery 10 is abnormal, the voltage difference established by the voltage generation module 310 between the safety member 320 and the battery 10 may be used for generating an arc effect between the two to form an arc. Specifically, after the voltage generation module 310 establishes the voltage difference between the safety member 320 and the battery 10, the voltage difference may be used for forming a certain current between the safety member 320 and the battery 10, and the current can break down some insulating media (such as air) between the safety member 320 and the battery 10 to generate instant sparks, thereby forming the arc. The arc carries relatively large energy and is capable of breaking down a container wall of the safety member 320. After the container wall is broken down, the safety substance therein is released so that the safety substance can perform safety control on the battery 10.

Through the technical solution of the embodiment of the present application, the safety member 320 accommodates the safety substance, and when the battery 10 is abnormal, the voltage difference actively established between the safety member 320 and the battery 10 by the voltage generation module 310 is capable of actively forming the arc between the safety member 320 and the battery 10. Through the arc with relatively large energy, the safety member 320 can be more effectively and quickly broken down, thereby releasing the safety substance accommodated in the safety member 320 to play a role in safety control of the battery 10, and further improving the safety performance of the battery 10.

Fig. 5 shows another schematic structural block diagram of a safety control mechanism 300 according to an embodiment of the present application.

As shown in Fig. 5, in the embodiment of the present application, the battery 10 includes a first battery cell 210. The voltage generation module 310 is used for establishing a voltage difference U between the safety member 320 and the battery 10, and when the first battery cell 210 is abnormal, the voltage difference U causes the safety member 320 to perform safety control.

Optionally, as shown in Fig. 5, the battery 10 may include at least one battery cell 20, and the at least one battery cell 20 is in series connection, in parallel connection, or in parallel-series connection through a busbar component 201 to output electric energy to the outside. The first battery cell 210 may be any one of the at least one battery cell 20. When the first battery cell 210 is abnormal, for example, when an operating parameter of the first battery cell 210 exceeds a preset parameter range, the voltage generation module 310 establishing the voltage difference U between the battery 10 where the first battery cell 210 is located and the safety member 320 can cause the safety member 320 to perform safety control on the battery 10.

Optionally, in the embodiment of the present application, the safety control mechanism 300 may be arranged inside the box body 100 of the battery 10 to perform safety control on the internal space of the battery 10. For example, the safety control mechanism 300 may perform safety control on at least some of the battery cells 20 in the battery 10 and/or spaces between the battery cells 20, thereby ensuring the safety performance of the battery 10.

Through the technical solution of the embodiment of the present application, the voltage generation module 310 can establish the voltage difference between the battery 10 and the safety member 320, and when the first battery cell 210 is abnormal, the safety member 320 can be caused through the voltage difference U to perform safety control on the battery 10. The technical solution is capable of performing safety control on the battery 10 according to the abnormality of the first battery cell 210 in the battery 10, so as to be capable of ensuring the safety performance of the battery 10 more reliably and in a targeted manner.

Fig. 6 shows another schematic structural block diagram of a safety control mechanism 300 according to an embodiment of the present application.

Optionally, as shown in Fig. 6, the voltage generation module 310 is used for establishing the voltage difference U between the safety member 320 and the first battery cell 210. The voltage difference U is used for forming an arc between the safety member 320 and the first battery cell 210 to break down the safety member 320, so that the safety member 320 releases a safety substance to perform safety control on the space where the first battery cell 210 is located and/or the space near the first battery cell 210.

As shown in Fig. 6, in the embodiment of the present application, the above safety member 320 may accommodate a safety substance (such as a fluid). When the first battery cell 210 is abnormal, the above voltage difference is used for forming an arc between the first battery cell 210 and the safety member 320 to break down the safety member 320, so that the safety member 320 releases the safety substance to perform safety control on the battery 10. For the convenience of description, the safety control function is described below by taking the safety substance being a fluid as an example.

Optionally, the safety member 320 can realize a temperature regulation function on at least one battery cell 20 in the battery 10 through the fluid accommodated inside it, and when the internal fluid is a fluid with a relatively low temperature, the fluid may be used for reducing the temperature of the at least one battery cell 20 to prevent the battery cell 20 from being overheated and causing potential safety hazards; when the internal fluid is a fluid with a relatively high temperature, the fluid may be used for increasing the temperature of the battery cell 20 to prevent the battery cell 20 from operating in a low temperature environment to affect its electrical performance.

When the first battery cell 210 is abnormal, the voltage difference U established by the voltage generation module 310 between the safety member 320 and the first battery cell 210 may be used for generating an arc effect between the two to form an arc. Specifically, after the voltage generation module 310 establishes the voltage difference U between the safety member 320 and the first battery cell 210, the voltage difference U may be used for forming a certain current between the safety member 320 and the first battery cell 210, and the current can break down some insulating media (such as air) between the safety member 320 and the first battery cell 210 to generate instant sparks, thereby forming the arc. The arc carries relatively large energy and is capable of breaking down a container wall of the safety member 320. After the container wall is broken down, the fluid therein flows out to control a related state, such as temperature, of the battery 10.

Through the technical solution of the embodiment of the present application, the safety member 320 accommodates the fluid, and when the safety member 320 is not broken down, the safety member 320 itself can have a certain temperature control function on the at least one battery cell 20 through the fluid. On this basis, the voltage difference U actively established by the voltage generation module 310 between the safety member 320 and the first battery cell 210 is capable of actively forming the arc between the safety member 320 and the first battery cell 210. Through the arc with relatively large energy, the safety member 320 can be more effectively and quickly broken down, so that the fluid accommodated in the safety member 320 flows to further control the at least one battery cell 20, thereby further improving the safety performance of the battery 10.

In some embodiments of the embodiments of the present application, the voltage difference U is used for forming an arc between the safety member 320 and the first battery cell 210 to break down the safety member 320, so that the fluid in the safety member 320 flows out to perform safety control on the space where the first battery cell 210 is located and/or the space near the first battery cell 210.

Optionally, in the embodiment, the arc formed between the safety member 320 and the first battery cell 210 can break down and destroy an area of the safety member 320 facing the first battery cell 210. At this time, the fluid flowing out from the safety member 320 can better control the space where the first battery cell 210 is located.

For example, when the first battery cell 210 is about to experience thermal runaway or has experienced thermal runaway, its internal temperature is relatively high, and at this time, the arc actively formed by the voltage generation module 310 between the first battery cell 210 and the safety member 320 causes the fluid in the safety member 320 to accurately and reliably reduce the temperature of the first battery cell 210, thereby preventing the heat generated by the first battery cell 210 from spreading and transferring to other battery cells in the battery 10, thus effectively ensuring the safety performance of the battery 10.

In addition, while the fluid plays a role in safety control on the space where the first battery cell 210 is located, the fluid can also flow to the space near the first battery cell 210 to perform safety control on the space near the first battery cell 210. The space near the first battery cell 210 refers to the space in a preset range with the first battery cell 210 as the center. The space near the first battery cell 210 includes the space where the battery cells 20 adjacent to the first battery cell 210 are located and the space between the adjacent battery cells 20, the " adjacent to the first battery cell 210" does not specifically refer to being directly adjacent to the first battery cell 210, but may also refer to being indirectly adjacent to the first battery cell 210.

Specifically, in the embodiment of the present application, in addition to perform safety control on the space where the first battery cell 210 is located, the fluid flowing out of the safety member 320 can further perform safety control on the battery cells 20 near the first battery cell 210, and/or, perform safety control on the space between the first battery cell 210 and nearby battery cells 20.

Alternatively, as a possible alternative embodiment, the arc formed between the safety member 320 and the first battery cell 210 can also break down and destroy an area in the safety member 320 near the battery cells 20 adjacent to the first battery cell 210. At this time, the fluid flowing out from the safety member 320 can better perform safety control on the battery cells 20 adjacent to the first battery cell 210.

Alternatively, as another possible alternative embodiment, the arc formed between the safety member 320 and the first battery cell 210 can also break down and destroy an area facing the first battery cell 210 and the area near the battery cells 20 adjacent to the first battery cell 210 in the safety member 320. At this time, the fluid flowing out from the safety member 320 can better perform safety control on the first battery cell 210 and the battery cells adjacent to the first battery cell 210.

Through the technical solution of the embodiment, the arc actively formed by the voltage generation module 310 between the first battery cell 210 and the safety member 320 can cause the fluid in the safety member 320 to precisely and reliably control the space where the first battery cell 210 is located and/or the space near first battery cell 210, thereby preventing heat generated by the first battery cell 210 in an abnormal state from spreading and transferring to other parts of the battery 10, and effectively ensuring the safety performance of the battery 10.

In some embodiments of the embodiments of the present application, the voltage difference U is used for forming the arc between the safety member 320 and the first battery cell 210 to break down the safety member 320 and a case of the first battery cell 210, so that the fluid in the safety member 320 flows out to perform control on the internal space of the first battery cell 210.

Specifically, in the embodiment, the arc formed between the safety member 320 and the first battery cell 210 can not only break down and destroy a container wall of the safety member 320, but also break down and destroy the case of the first battery cell 210. As an example, when the first battery cell 210 is abnormal and its internal temperature is high, the arc destroys the case of the first battery cell 210, which can facilitate the fluid flowing out from the safety member 320 to accurately and efficiently reduce the temperature of the interior of the first battery cell 210, thereby preventing the heat generated by the first battery cell 210 in the abnormal state from spreading to other battery cells, and further improving the safety performance of the battery 10.

Specifically, in the embodiment of the present application, the voltage difference U established between the safety member 320 and the first battery cell 210 by the voltage generation module 310 may be adjusted, thereby adjusting the energy of the arc formed between the safety member 320 and the first battery cell 210, such that the arc only breaks down the container wall of the safety member 320 or simultaneously breaks down the container wall of the safety member 320 and the case of the first battery cell 210.

Optionally, the voltage difference U is related to at least one of the following parameters: the wall thickness of the safety member 320, the distance between the safety member 320 and the first battery cell 210, and the corresponding area between the safety member 320 and the first battery cell 210.

In some embodiments, the voltage difference U for forming the arc may be determined by at least one of the above parameters.

As an example, the voltage difference U and the wall thickness T of the safety member 320 may meet the following relationship: 1≤U/T≤5000, wherein the unit of the voltage difference U is V, and the unit of the wall thickness T of the safety member 320 is mm.

As another example, the voltage difference U and the distance d between the safety member 320 and the first battery cell 210 meet the following relationship: U/d≥2, wherein the unit of the voltage difference U is V, and the unit of the distance d between the safety member 320 and the first battery cell 210 is mm.

As a third example, the voltage difference and the corresponding area between the safety member 320 and the first battery cell 210 meet the following relationship: U/S≥0.00008, wherein the unit of the voltage difference U is V, and the unit of the corresponding area S between the safety member 320 and the first battery cell 210 is mm².

Through the technical solution of the embodiments of the present application, when designing the voltage difference U between the safety member 320 and the first battery cell 210, the safety member 320, the first battery cell 210, and relevant parameters in an environment in which the two are located may be comprehensively considered to obtain a more suitable voltage difference, thereby generating a more stable and controllable arc.

Optionally, in some embodiments, the voltage difference U may range from 4 V to 1000 V. Further, the voltage difference U may range from 10 V to 500 V. Even further, the voltage difference U may range from 20 V to 200 V. Even further, the voltage difference U may range from 20 V to 100 V. Alternatively, even further, the voltage difference U may range from 30 V to 60 V.

Through the technical solution of the embodiment, the voltage difference U is controlled within the range of 4 V to 1000 V or a more precise voltage difference range, the voltage difference U can form the arc between the safety member 320 and the first battery cell 210, and the arc can break down the container wall of the safety member 320 to release the safety substance, thereby comprehensively ensuring the safety performance of the battery 10.

Specifically, in the above application embodiments, when the first battery cell 210 is abnormal, the voltage difference U between the safety member 320 and the battery 10 drives the safety member 320 or causes the safety member 320 to actuate. The voltage difference U may be established before the first battery cell 210 is abnormal, but it has no effect on the first battery cell 210 that is not abnormal, or the voltage difference U may be established synchronously when the first battery cell 210 is abnormal, so that when the first battery cell 210 operates normally, the voltage different U has no effect on it, thereby ensuring the operation performance of the battery 10.

In addition, the safety member 320 may not establish a voltage difference with another battery cell 20 in the battery 10, or, when another battery cell 20 operates normally, a voltage difference between the safety member 320 and the other battery cell 20 will not affect the other battery cell 20, thereby ensuring the normal operation of the battery 10.

Optionally, in the embodiment shown in Fig. 6, the first battery cell 210 and the safety member 320 are insulated from each other. When the first battery cell 210 is abnormal, the insulation between the first battery cell 210 and the safety member 320 fails, and the voltage difference U between the first battery cell 210 and the safety member 320 causes the safety member 320 to perform safety control.

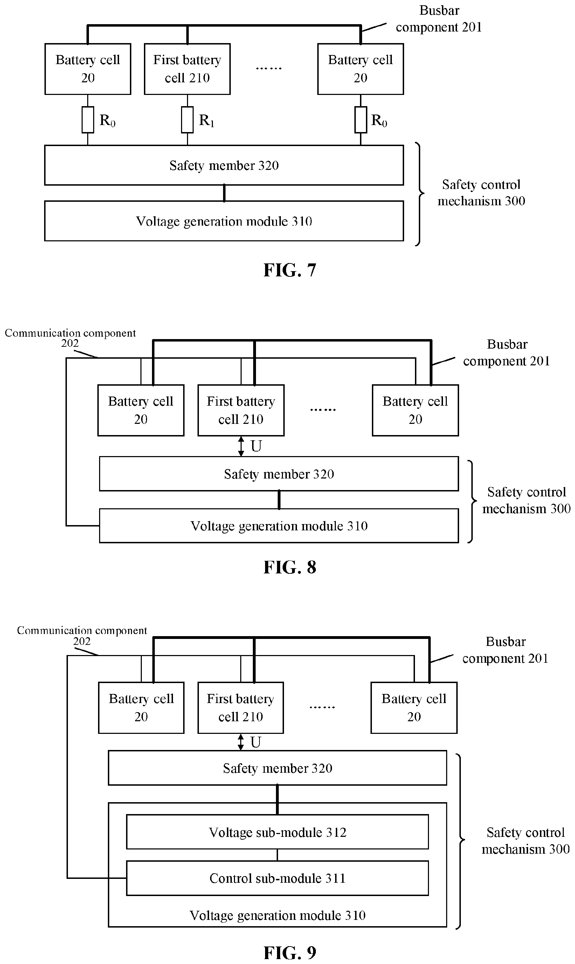

In this case, Fig. 7 shows another schematic structural block diagram of a safety control mechanism 300 according to an embodiment of the present application.

As shown in Fig. 7, in the embodiment of the present application, in the battery 10, each battery cell 20 in at least one battery cell 20 and the safety member 320 are insulated from each other. When the first battery cell 210 is abnormal, the insulation between the first battery cell 210 and the safety member 320 fails, and the voltage difference U between the first battery cell 210 and the safety member 320 causes the safety member 320 to perform safety control on the battery 10.

As shown in Fig. 7, there may be an insulation design between the safety member 320 and the at least one battery cell 20, and the insulation design results in an insulation equivalent resistance R₀ formed between the safety member 320 and each battery cell 20. The insulation equivalent resistance R₀ has a large resistance value, and when a human body accidentally touches the battery 10 where the at least one battery cell 20 is located, the insulation equivalent resistance R₀ can prevent the battery 10 from damaging the human body, thereby ensuring the safety of the human body. Optionally, the insulation equivalent resistance R₀ may be designed according to relevant standards or actual needs, and the specific resistance value of the insulation equivalent resistance R₀ is not limited in the embodiment of the present application.

When the insulation design between the first battery cell 210 in the at least one battery cell 20 and the safety member 320 is affected by the first battery cell 210 or other components, the insulation equivalent resistance R₀ between the first battery cell 210 and the safety member 320 is greatly reduced, and at this time, the insulation performance between the first battery cell 210 and the safety member 320 is reduced, or in other words, insulation failure is generated between the first battery cell 210 and the safety member 320.

As shown in Fig. 7, in the case that the insulation failure is generated between the first battery cell 210 and the safety member 320, the equivalent resistance between the first battery cell 210 and the safety member 320 is reduced from the insulation equivalent resistance R₀ to an insulation failure equivalent resistance R₁.

In the case that the voltage generation module 310 establishes the voltage difference U between the safety member 320 and the first battery cell 210, when the insulation performance between the first battery cell 210 and the safety member 320 is good, there is a relatively large insulation equivalent resistance R₀ between the first battery cell 210 and the safety member 320, and therefore, the current between the first battery cell 210 and the safety member 320 is very small or even almost zero. In the case that the insulation failure is generated between the first battery cell 210 and the safety member 320, the resistance between the first battery cell 210 and the safety member 320 may be greatly reduced to form the insulation failure equivalent resistance Ri, and therefore, under the action of the voltage difference U, a certain current may be formed between the first battery cell 210 and the safety member 320, so as to drive the safety member 320 or cause the safety member 320 to actuate, thereby performing safety control on the battery 10.

Through the technical solution of the embodiment of the present application, in the battery 10, the mutual insulation between the first battery cell 210 and the safety member 320 can ensure that the safety member 320 has little impact on the first battery cell 210 and ensure the safety performance of the first battery cell 210 in a normal operating state. On this basis, the abnormality of the first battery cell 210 may cause an insulation failure between it and the safety member 320, and then the safety member 320 is caused to perform safety control on the battery 10 where the first battery cell 210 is located. The overall embodiment has a high degree of pertinence and reliability.

Optionally, in some embodiments, an insulation layer is arranged between the first battery cell 210 and the safety member 320 to achieve the mutual insulation between the first battery cell 210 and the safety member 320. In the embodiment, when the first battery cell 210 is abnormal, the state of the insulation layer between the first battery cell 210 and the safety member 320 changes, so that the insulation between the first battery cell 210 and the safety member 320 fails.

Optionally, when the first battery cell 210 experiences thermal runaway or is about to experience thermal runaway, the temperature of the first battery cell 210 is relatively high. Affected by the high temperature, the insulation layer between the first battery cell 210 and the safety member 320 is heated and melted, so that the insulation equivalent resistance R₀ between the first battery cell 210 and the safety member 320 is reduced to form the insulation failure.

Optionally, in order to ensure that the insulation layer is capable of responding to the abnormal state of the first battery cell 210 and melt when the temperature of the first battery cell 210 is high, the melting point of the insulation layer may be lower than 800°C.

Alternatively, in other embodiments, the insulation layer between the first battery cell 210 and the safety member 320 may be controlled or influenced by other factors to change its state. For example, when the first battery cell 210 is abnormal, the insulation layer between it and the safety member 320 may be subjected to an external effect, causing damage or a change in a physical state of another type, so that the insulation equivalent resistance R₀ between the first battery cell 210 and the safety member 320 is reduced to form the insulation failure.

Therefore, in the technical solution of the embodiment, the insulation design of the insulation layer between the first battery cell 210 and the safety member 320 is easy to be implemented in the battery 10 and is capable of ensuring the insulation performance. Further, the insulation layer is capable of responding to an abnormal state such as thermal runaway of the first battery cell 210, so that an effective insulation failure is formed between the first battery cell 210 and the safety member 320, and the safety member 320 is caused to perform safety control on the battery 10 where the first battery cell 210 is located, thereby preventing or eliminating the safety impact of the heat generated by the first battery cell 210 on the battery 10.

It should be noted that, in the above embodiment shown in Fig. 7, in addition to the insulation equivalent resistance R₀ that can be formed between the safety member 320 and at least one battery cell 20, an equivalent resistance having another value may also be formed. A resistance value of the equivalent resistance may not reach the order of magnitude of the insulation resistance value, and it may be another resistance having a large resistance value. When a voltage generator 3121 establishes the voltage difference U between the first battery cell 210 and the safety member 320 before the first battery cell 210 is abnormal, the equivalent resistance between the safety member 320 and the first battery cell 210 can make the voltage difference U have less influence on the safety member 320 and the first battery cell 210.

Alternatively, in the embodiment shown in Fig. 7 above, the equivalent resistance between the safety member 320 and the at least one battery cell 20 may also be designed to be small or even zero. In this case, the voltage generator 3121 may establish the voltage difference U between the first battery cell 210 and the safety member 320 when the first battery cell 210 is abnormal.

In this case, for preventing the safety member 320 from affecting other battery cells 20, the safety member 320 is arranged corresponding to the first battery cell 210 in the at least one battery cell 20, but not corresponding to other battery cells 20, thereby ensuring the operating performance of the other normal battery cells 20 in the battery 10.

Alternatively, in the case that the equivalent resistance between the safety member 320 and the at least one battery cell 20 is the insulation equivalent resistance R₀ or another resistance with a relatively large resistance, the safety member 320 may also be arranged corresponding to the first battery cell 210 without corresponding to the other battery cells 20.

For the above application examples, in some embodiments, the voltage generation module 310 may be directly connected to the safety member 320, so that the voltage difference is formed between the safety member 320 and the battery 10. In the embodiment, the voltage difference may be established before the battery 10 is abnormal.

Alternatively, in some other embodiments, the voltage generation module 310 may further be used for acquiring a characteristic signal of the battery 10, the characteristic signal of the battery 10 being used for indicating that the battery 10 is abnormal; and the voltage generation module 310 is used for establishing the voltage difference between the safety member 320 and the battery 10 according to the characteristic signal of the battery 10. In the embodiment, the voltage difference may be established simultaneously when the battery 10 is abnormal.

Specifically, in the technical solution of the embodiment, the characteristic signal of the battery 10 may include: a state signal reflecting the abnormal state of the battery 10. For example, the characteristic signal of the battery 10 may include: a characteristic signal of at least one battery cell 20 in the battery 10, and/or a characteristic signal of another component in the battery 10. The characteristic signal includes, but is not limited to, an electrical parameter (such as current or voltage), temperature, pressure, characteristic gas, stress, or the like. When the battery 10 is in the abnormal state, a signal value of the characteristic signal of the battery 10 is different from a signal value of the battery 10 in a normal state. From the signal value of the characteristic signal of the battery 10, it can be determined that the battery 10 is in the abnormal state.

As an example and not limitation, the characteristic signal of the battery 10 may be used for indicating that the battery 10 is in a thermal runaway state and/or is in a critical state within a preset time period before the thermal runaway state. Specifically, when any one of the battery cells 20 in the battery 10 experiences thermal runaway or is about to experience thermal runaway, the characteristic signals such as the electrical parameter of the battery 10, the temperature, pressure, and characteristic gas inside the battery 10, and the local stress on the box body of the battery 10 may all change as compared with those in the normal state. The voltage generation module 310 can determine, by acquiring the characteristic signal of the battery 10, that the battery cell 20 inside the battery 10 experiences thermal runaway or is about to experience thermal runaway, so as to establish the voltage difference between the safety member 320 and the battery 10, and cause the safety member 320 to perform safety control on the battery 10.

Through the technical solution of the embodiment of the present application, the voltage generation module 310 is capable of acquiring the characteristic signal used for indicating the abnormality of the battery 10, and establishing the voltage difference between the safety member 320 and the battery 10 according to the characteristic signal, so that the voltage generation module 310 is caused to be capable of performing relatively reliable safety control on the battery 10 in an abnormal state in time.

Optionally, the above characteristic signal of the battery 10 may include: a characteristic signal of the first battery cell 210 in the battery 10, and the characteristic signal of the first battery cell 210 is used for indicating that the first battery cell 210 is in the abnormal state.

In the embodiment, Fig. 8 shows another schematic structural block diagram of a safety control mechanism 300 according to an embodiment of the present application.

Optionally, as shown in Fig. 8, the voltage generation module 310 may be connected to at least one battery cell 20 in the battery 10 through a communication component 202, so as to acquire a signal of the at least one battery cell 20. The communication component 202 includes, but is not limited to, a signal collection harness or another communication device for signal transmission. In addition, the voltage generation module 310 can be connected to the at least one battery cell 20 through the communication component 202, and can also be connected to another component in the battery 10 through the communication component 202, so as to obtain a signal of the other component.

Specifically, the voltage generation module 310 may be used for acquiring the characteristic signal of the first battery cell 210 in the battery 10, and establishing, according to the characteristic signal of the first battery cell 210, the voltage difference U between the safety member 320 and the first battery cell 210. The characteristic signal of the first battery cell 210 is used for indicating that the first battery cell 210 is abnormal.

In the embodiment, the characteristic signal of the first battery cell 210 may include at least one parameter of the first battery cell 210: electrical parameter, temperature, pressure, characteristic gas, or stress.

When the first battery cell 210 is abnormal, the first battery cell 210 is in an abnormal state, and the abnormal state may be another state different from the normal operating state, for example, the abnormal state of the first battery cell 210 may be a thermal runaway state and/or a critical state within a predetermined time period before the thermal runaway state. Alternatively, the abnormal state of the first battery cell 210 may be other monitorable abnormal states besides the thermal runaway state and/or the critical state of the thermal runaway state, and the type of the abnormal state is not specifically limited in the embodiment of the present application.

Through the technical solution of the embodiment of the present application, the voltage generation module 310 is capable of accurately and timely forming the voltage difference between the safety member 320 and the first battery cell 210 according to the characteristic signal of the first battery cell 210, so that the safety member 320 is capable of quickly performing precise safety control on the first battery cell 210.

Further, when the characteristic signal of the first battery cell 210 is used for indicating that the first battery cell 210 is in the thermal runaway state and/or in the critical state within the preset time period before the thermal runaway state, the voltage generation module 310 and the safety member 320 in the safety control mechanism 300 cooperate with each other to perform fire-fighting on the first battery cell 210 in the thermal runaway state and/or the critical state in time or even in advance, thereby preventing internal heat of the first battery cell 210 from spreading in the battery 10 and affecting the performance of other battery cells, quickly performing safety control on the battery 10 where the first battery cell 210 is located, and thus being capable of greatly improving the safety performance of the battery 10.

Optionally, the voltage generation module 310 can acquire the characteristic signal of the first battery cell 210 in the battery 10; in addition, the voltage generation module 310 can further acquire a characteristic signal of a battery cell adjacent to the first battery cell 210 in the battery 10 in another alternative embodiment, and establish, according to the characteristic signal of the first battery cell 210 and/or the characteristic signal of the battery cell adjacent to the first battery cell 210, the voltage difference U between the safety member 320 and the first battery cell 210.

Optionally, after acquiring the characteristic signal of the first battery cell 210 and/or the battery cell adjacent to the first battery cell 210 in the battery 10, in addition to establishing the voltage difference U between the safety member 320 and the first battery cell 210, the voltage generation module 310 may further establish a voltage difference between the safety member 320 and the adjacent battery cell (adjacent to the first battery cell 210).

Fig. 9 shows another schematic structural block diagram of a safety control mechanism 300 according to an embodiment of the present application.

As shown in Fig. 9, in the embodiment of the present application, the voltage generation module 310 includes: a control sub-module 311 and a voltage sub-module 312; the control sub-module 311 is used for acquiring the characteristic signal of the battery 10 (not shown in Fig. 9), and controlling, according to the characteristic signal of the battery 10, the voltage sub-module 312 to establish the voltage difference between the safety member 320 and the battery 10.

Specifically, in the embodiment of the present application, the control sub-module 311 may send a first control signal to the voltage sub-module 312 according to the characteristic signal of the battery 10, and the voltage sub-module 312 may, under the control of the first control signal, establish the voltage difference between the safety member 320 and the battery 10. In addition, the control sub-module 311 further sends a second control signal to the voltage sub-module 312 according to another signal of the battery 10, and the voltage sub-module 312 may further cancel, under the control of the second control signal, the voltage difference established between the safety member 320 and the battery 10, thereby reducing the influence of the safety member 320 on the safety performance of the battery 10, and further improving the safety control performance of the safety control mechanism 300 on the battery 10.

Optionally, in the embodiment shown in Fig. 9, the control sub-module 311 may be connected to at least one battery cell 20 in the battery 10 through the communication component 202, so as to acquire a signal of the at least one battery cell 20. When the first battery cell 210 in the at least one battery cell 20 is abnormal, the control sub-module 311 is used for acquiring the characteristic signal of the first battery cell 210 and controlling, according to the characteristic signal, the voltage sub-module 312 to establish the voltage difference U between the safety member 320 and the first battery cell 210.

Optionally, in some embodiments, the control sub-module 311 may be a Battery Management System (BMS) for managing the battery 10, or, in other embodiments, the control sub-module 311 may also be a control device of another type, and the specific embodiment of the control sub-module 311 is not limited in the embodiment of the present application.

Through the technical solution of the embodiment of the present application, the control sub-module 311 is arranged in the voltage generation module 310, and the control sub-module 311 is capable of flexibly controlling the voltage sub-module 312 to establish the voltage difference between the safety member 320 and the battery 10. Compared with the technical solution in which the voltage generation module 310 continuously establishes the voltage difference between the safety member 320 and the battery 10, the technical solution can reduce the impact of the continuous voltage difference between the safety member 320 and the battery 10 on the safety performance of the battery 10, and further improve the safety management performance the safety control mechanism 300 on the battery 10.

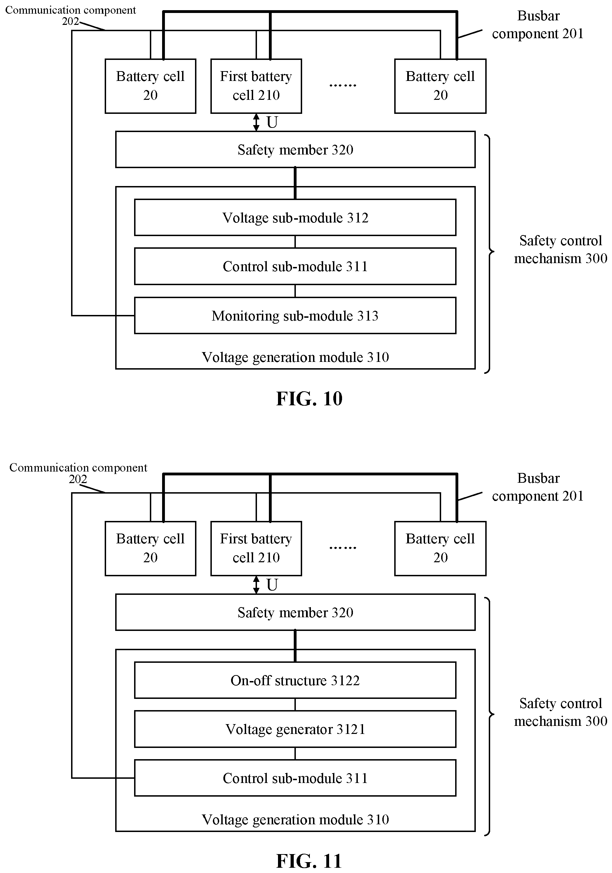

Fig. 10 shows another schematic structural block diagram of a safety control mechanism 300 according to an embodiment of the present application.

As shown in Fig. 10, in the embodiment of the present application, the voltage generation module 310 further includes: a monitoring sub-module 313, for monitoring the characteristic signal of the battery 10 and sending the characteristic signal of the battery 10 (not shown in Fig. 10) to the control sub-module 311. The control sub-module 311 is used for receiving the characteristic signal of the battery 10 sent by the monitoring sub-module 313, and controlling, according to the characteristic signal, the voltage sub-module 312 to establish the voltage difference between the safety member 320 and the battery 10.

Specifically, the embodiment of the present application provides an independent monitoring sub-module 313 for real-time monitoring the operating state of the battery 10, for example, the monitoring sub-module 313 is used for real-time monitoring the signal of each battery cell 20 in the battery 10 and/or signals from other components in the battery 10. Optionally, the monitoring sub-module 313 includes, but is not limited to, a Cell Supervision Circuit (CSC) or another module for monitoring the operating state of the battery 10.

Optionally, in the embodiment shown in Fig. 10, the monitoring sub-module 313 may be used for monitoring at least one battery cell 20 in the battery 10 in real time, and when the first battery cell 210 in the at least one battery cell 20 is abnormal, the monitoring sub-module 313 sends the characteristic signal of the first battery cell 210 to the control sub-module 311. The control sub-module 311 is used for controlling, according to the characteristic signal of the first battery cell 210, the voltage sub-module 312 to establish the voltage difference U between the safety member 320 and the first battery cell 210.

Optionally, there may be one or a plurality of monitoring sub-modules 313, and when there are a plurality of monitoring sub-modules 313, they may be distributed and arranged in the box body of the battery 10, so as to comprehensively monitor the characteristic signals of at least one battery cell 20 and other components inside the battery 10 through the plurality of monitoring sub-modules 313.

Through the technical solution of the embodiment of the present application, the independent monitoring sub-module 313 is arranged in the safety control mechanism 300, which can be used for actively monitoring the characteristic signal of the battery 10 in real time, so that the safety control mechanism 300 is caused to perform a more timely and effective safety management on the battery 10, thereby further improving the safety performance of the battery 10.

Fig. 11 shows another schematic structural block diagram of a safety control mechanism 300 according to an embodiment of the present application.

As shown in Fig. 11, in the embodiment of the present application, the voltage sub-module 312 (not shown in the figure) includes: a voltage generator 3121 and an on-off structure 3122, and the voltage generator 3121 is connected to the safety member 320 through the on-off structure 3122. The control sub-module 311 is used for controlling, according to the characteristic signal of the battery 10 (not shown in the figure), the on-off structure 3122 to be turned on, so that the voltage generator 3121 establishes the voltage difference between the safety member 320 and the battery 10.

Specifically, in the embodiment of the present application, the voltage generator 3121 may be a power supply, a voltage generating circuit, or other modules carrying electrical energy, which is capable of electrifying the safety member 320 to establish the voltage difference between the safety member 320 and the battery 10. Optionally, the voltage generator 3121 may be a power supply apparatus inside the battery 10, such as the battery cell 20 inside the battery 10, or the voltage generator 3121 may also be a power supply apparatus outside the battery 10, and the specific location of the voltage generator 3121 is not limited in the embodiment of the present application.

The on-off structure 3122 includes, but is not limited to, an electrical switch, the voltage generator 3121 may be connected to the safety member 320 through the electrical switch, and the electrical switch may be turned on or off under the control of the control sub-module 311. Of course, in addition to the electrical switch, the on-off structure 3122 may also be an electrical device or mechanical structure of another type. The on-off structure 3122 aims to be capable of implementing connection and disconnection between the safety member 320 and the voltage generator 3121 under the control of the control sub-module 311, and the specific embodiment of the on-off structure 3122 is not limited in the embodiment of the present application.

Optionally, as shown in Fig. 11, in addition to connecting to at least one battery cell 20 through the communication component 202, the control sub-module 311 may also establish a connection with the on-off structure 3122 through the communication component 202, and the on-off structure 3122 may receive a control signal of the control sub-module 311 to realize the connection and disconnection between the safety member 320 and the voltage generator 3121.

Specifically, the control sub-module 311 may acquire the characteristic signal of at least one battery cell 20 and/or another component in the battery 10, and the control sub-module 311 may determine, according to the characteristic signal, that the battery 10 is in an abnormal state different from the normal state, and in this case, the control sub-module 311 controls the on-off structure 3122 to be turned on, so as to connect the safety member 320 and the voltage generator 3121, and cause the voltage generator 3121 to establish the voltage difference between the safety member 320 and the battery 10.

Optionally, in the embodiment shown in Fig. 11, when the first battery cell 210 in the at least one battery cell 20 is abnormal, the control sub-module 311 is used for acquiring the characteristic signal of the first battery cell 210 and controlling, according to the characteristic signal, the on-off structure 3122 to be turned on, so as to cause the voltage generator 3121 to establish the voltage difference U between the safety member 320 and the first battery cell 210.

It should be noted that, in addition to being directly connected to the at least one battery cell 20 through the communication component 202 as shown in Fig. 11, the control sub-module 311 may further be connected to the at least one battery cell 20 through the monitoring sub-module 313, and the control sub-module 311 is used for receiving the characteristic signal of the at least one battery cell 20 sent by the monitoring sub-module 313.

Through the technical solution of the embodiment of the present application, the voltage sub-module 312 includes the voltage generator 3121 and the on-off structure 3122, and the on-off structure 3122 is capable of realizing the connection between the safety member 320 and the voltage generator 3121 under the control of the control sub-module 311. The overall solution is simple in implementation and high in reliability, and will not bring too much extra cost to the safety control mechanism 300.

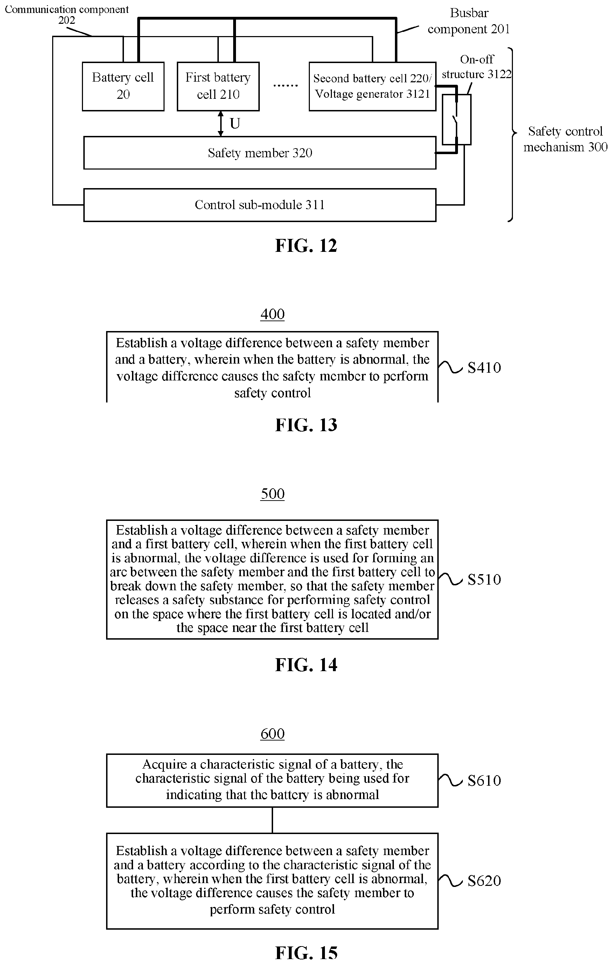

Fig. 12 shows another schematic structural block diagram of a safety control mechanism 300 according to an embodiment of the present application.

As shown in Fig. 12, in the embodiment of the present application, the voltage generator 3121 includes: a second battery cell 220 in the battery 10.

That is, in the embodiment of the present application, the second battery cell 220 in the battery 10 may be reused as the voltage generator 3121, and the second battery cell 220 may be any other battery cell in the battery 10 except the first battery cell 210, and the second battery cell 220 is capable of providing electric energy to the outside.

Optionally, as shown in Fig. 12, in the embodiment of the present application, the on-off structure 3122 is connected between the second battery cell 220 and the safety member 320, so that the second battery cell 220 can establish, through the on-off structure 3122, the voltage difference U between the safety member 320 and the first battery cell 210.

Through the technical solution of the embodiment of the present application, the second battery cell 220 in the battery 10 is reused as the voltage generator 3121, and there is no need to add an additional voltage generator in the system where the battery 10 is located, thereby saving the space occupied by the safety control mechanism 300 in the system where the battery 10 is located, which is beneficial to reduce the overall volume of the system where the battery 10 is located and the cost required for production.

The safety control mechanism 300 of the embodiment of the present application is described above with reference to Fig. 3 to Fig. 12. A safety control method according to an embodiment of the present application will be described below with reference to Fig. 13 to Fig. 15, and parts not described in detail may be obtained with reference to the foregoing embodiments.

Fig. 13 shows a schematic flow chart of a safety control method 400 according to an embodiment of the present application. The safety control method 400 may be used for performing safety control on a battery, for example, the battery 10 as described above.

As shown in Fig. 13, in the embodiment of the present application, the safety control method 400 may include the following steps.

S410: Establish a voltage difference between a safety member and a battery, wherein when the battery is abnormal, the voltage difference causes the safety member to perform safety control.

Specifically, in the embodiment of the present application, an execution subject of the above step S410 may be the voltage generation module 310 in the above apparatus embodiment, and the safety member in the step S410 may be the safety member 320 in the above apparatus embodiment. That is, in the embodiment of the present application, the voltage generation module 310 establishes the voltage difference between the safety member 320 and the battery 10. The relevant technical solutions of the voltage generation module 310, the safety member 320, and the voltage difference may be obtained with reference to the relevant descriptions of the above apparatus embodiments, and will not be repeated here.

Optionally, in some embodiments, the safety member accommodates a safety substance; and the voltage difference causing the safety member to perform safety control includes: the voltage difference being used for forming an arc between the safety member and the battery to break down the safety member, so that the safety member releases the safety substance for performing safety control.

Optionally, in some embodiments, the battery includes a first battery cell; and the when the battery is abnormal, the voltage difference causing the safety member to perform safety control includes: when the first battery cell is abnormal, the voltage difference causing the safety member to perform safety control.

Fig. 14 shows a schematic flow chart of another safety control method 500 according to an embodiment of the present application.

As shown in Fig. 14, in the embodiment of the present application, the safety control method 500 may include the following steps.

S510: Establish a voltage difference between a safety member and a first battery cell in at least one battery cell, and when a first battery cell is abnormal, the voltage difference is used for forming an arc between the safety member and the first battery cell to break down the safety member, so that the safety member releases a safety substance for performing safety control on the space where the first battery cell is located and/or the space near the first battery cell.

In some possible embodiments, the voltage difference is used for forming the arc between the safety member and the first battery cell to break down the safety member and a case of the first battery cell, so that the safety member releases the safety substance to perform safety control on the internal space of the first battery cell.

In some possible embodiments, the voltage difference is related to at least one of the following parameters: the wall thickness of the safety member, the distance between the safety member and the first battery cell, and the corresponding area between the safety member and the first battery cell.

In some possible embodiments, the voltage difference and the wall thickness of the safety member meet the following relationship: 1≤U/T≤5000, wherein U is the voltage difference in V, and T is the wall thickness of the safety member in mm; and/or the voltage difference and the distance between the safety member and the first battery cell meet the following relationship: U/d≥2, wherein U is the voltage difference in V, and d is the distance between the safety member and the first battery cell in mm; and/or, the voltage difference and the corresponding area between the safety member and the first battery cell meet the following relationship: U/S≥0.00008, where U is the voltage difference in V, and S is the corresponding area between the safety member and the first battery cell in mm².

In some possible embodiments, the voltage difference ranges from 4 V to 1000 V.

In some possible embodiments, the first battery cell and the safety member are insulated from each other. When the first battery cell is abnormal, the insulation between the first battery cell and the safety member fails, and the voltage difference between the first battery cell and the safety member causes the safety member to perform safety control.

In some possible embodiments, when the first battery cell is abnormal, an insulation layer between the first battery cell and the safety member is heated and melted, so that the insulation between the first battery cell and the safety member fails.

In some possible embodiments, the safety member is arranged corresponding to the first battery cell in at least one battery cell.

Fig. 15 shows a schematic flow chart of another safety control method 600 according to an embodiment of the present application. The safety control method 600 may be used for performing safety control on the battery 10 including at least one battery cell 20.

As shown in Fig. 15, in the embodiment of the present application, the safety control method 600 may include the following steps.

S610: Acquire a characteristic signal of the battery, the characteristic signal of the battery being used for indicating that the battery is abnormal.

S620: Establish a voltage difference between a safety member and the battery according to the characteristic signal of the battery, wherein when the battery is abnormal, the voltage difference causes the safety member to perform safety control.

In some possible embodiment manners, the safety control method 600 is applied to the voltage generation module 310 in the above apparatus embodiment, and the voltage generation module 310 includes: the control sub-module 311 and the voltage sub-module 312.

In this case, the above step S610 may include: acquiring a characteristic signal of the battery by the control sub-module 311. The above step S620 may include: controlling, by the control sub-module 311, the voltage sub-module 312 to establish the voltage difference between the safety member and the battery according to the characteristic signal of the battery.

In some possible embodiments, the voltage generation module 310 further includes: the monitoring sub-module 313; and in this case, the safety control method 600 further includes: monitoring, by the monitoring sub-module 313, the characteristic signal of the battery and sending the characteristic signal of the battery to the control sub-module 311.

In some possible embodiments, the voltage sub-module 312 includes: the voltage generator 3121 and the on-off structure 3122, and the voltage generator 3121 is connected to the safety member through the on-off structure 3122. In this case, the above step S620 may include: controlling, by the control sub-module 311 according to the characteristic signal of the battery, the on-off structure 3122 to be turned on, so that the voltage generator 3121 establishes the voltage difference between the safety member and the battery.

In some possible embodiments, the voltage generator 3121 includes: a second battery cell in the at least one battery cell.

In some possible embodiments, the characteristic signal of the battery is used for indicating that the battery is in a thermal runaway state and/or in a critical state within a preset time period before the thermal runaway state.

In some possible embodiments, the characteristic signal of the battery includes at least one of the following signals: electrical parameter, temperature, pressure, characteristic gas, or stress.

In some possible embodiment manners, the characteristic signal of the battery includes: a characteristic signal of the first battery cell in the battery. In this case, the above step S610 may include: acquiring the characteristic signal of the first battery cell. The above step S620 may include: establishing the voltage difference between the safety member and the first battery cell according to the characteristic signal of the first battery cell.

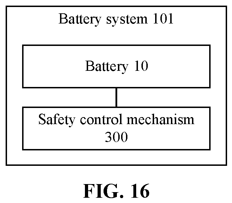

Fig. 16 shows a schematic structural block diagram of a battery system 101 according to an embodiment of the present application.

As shown in Fig. 16, the battery system 101 may include the battery 10 and the safety control mechanism 300 in the aforementioned embodiments of the present application, and the safety control mechanism 300 is used for performing safety control on the battery 10.

An embodiment of the present application further provides an electrical apparatus. The electrical apparatus may include the battery system 101 in the foregoing embodiment, and the battery system 101 is used for supplying electric energy to the electrical apparatus.

In some embodiments, the electrical apparatus may be a vehicle 1, a ship, or a spacecraft.

Although the present application has been described with reference to the preferred embodiments, various improvements may be made thereto and components thereof may be replaced with equivalents without departing from the scope of the present application. In particular, the technical features mentioned in the various embodiments may be combined in any manner as long as there is no structural conflict. The present application is not limited to the specific embodiments disclosed herein, but rather includes all technical solutions falling within the scope of the claims.

## Claims

1. A safety control mechanism, used for performing safety control on a battery, wherein the safety control mechanism comprises: a voltage generation module and a safety member;
the voltage generation module is used for establishing a voltage difference between the safety member and the battery, and when the battery is abnormal, the voltage difference causing the safety member to perform safety control.

2. The safety control mechanism according to claim 1, wherein the safety member accommodates a safety substance; and
the voltage difference causing the safety member to perform safety control comprises:
the voltage difference being used for forming an arc between the safety member and the battery to break down the safety member, so that the safety member releases the safety substance for performing safety control.

3. The safety control mechanism according to claim 2, wherein the battery comprises a first battery cell; and
the when the battery is abnormal, the voltage difference causing the safety member to perform safety control comprises:
when the first battery cell is abnormal, the voltage difference causing the safety member to perform safety control.

4. The safety control mechanism according to claim 3, wherein the voltage generation module being used for establishing a voltage difference between the safety member and the battery comprises:
the voltage generation module being used for establishing the voltage difference between the safety member and the first battery cell;
the voltage difference being used for forming an arc between the safety member and the battery to break down the safety member, so that the safety member releases the safety substance for performing safety control comprises:
the voltage difference being used for forming an arc between the safety member and the first battery cell to break down the safety member, so that the safety member releases the safety substance for performing safety control on the space where the first battery cell is located and/or the space near the first battery cell.

5. The safety control mechanism according to claim 4, wherein the voltage difference being used for forming an arc between the safety member and the first battery cell to break down the safety member, so that the safety member releases the safety substance for performing safety control on the space where the first battery cell is located comprises:
the voltage difference being used for forming the arc between the safety member and the first battery cell to break down the safety member and a case of the first battery cell, so that the safety member releases the safety substance to perform safety control on the internal space of the first battery cell.

6. The safety control mechanism according to claim 4 or 5, wherein the voltage difference is related to at least one of the following parameters:
the wall thickness of the safety member, the distance between the safety member and the first battery cell, and the corresponding area between the safety member and the first battery cell.

7. The safety control mechanism according to claim 6, wherein the voltage difference and the wall thickness of the safety member meet the following relationship: 1≤U/T≤5000, wherein U is the voltage difference in V, and T is the wall thickness of the safety member in mm; and/or,
the voltage difference and the distance between the safety member and the first battery cell meet the following relationship: U/d≥2, wherein U is the voltage difference in V, and d is the distance between the safety member and the first battery cell in mm; and/or,
the voltage difference and the corresponding area between the safety member and the first battery cell meet the following relationship: U/S≥0.00008, wherein U is the voltage difference in V, and S is the corresponding area between the safety member and the first battery cell in mm².

8. The safety control mechanism according to any one of claims 1 to 7, wherein the voltage difference ranges from 4 V to 1000 V.

9. The safety control mechanism according to any one of claims 3 to 8, wherein the first battery cell and the safety member are insulated from each other; and
the when the first battery cell is abnormal, the voltage difference causing the safety member to perform safety control comprises:
when the first battery cell is abnormal, the insulation between the first battery cell and the safety member failing, and the voltage difference between the first battery cell and the safety member causing the safety member to perform safety control.

10. The safety control mechanism according to claim 9, wherein when the first battery cell is abnormal, a state of an insulation layer between the first battery cell and the safety member changes, so that the insulation between the first battery cell and the safety member fails.

11. The safety control mechanism according to any one of claims 3 to 10, wherein the safety member is arranged corresponding to the first battery cell.

12. The safety control mechanism according to any one of claims 1 to 11, wherein the voltage generation module being used for establishing a voltage difference between the safety member and the battery comprises:
the voltage generation module being used for acquiring a characteristic signal of the battery, and the characteristic signal of the battery being used for indicating that the battery is abnormal; and
the voltage generation module being used for establishing the voltage difference between the safety member and the battery according to the characteristic signal of the battery.

13. The safety control mechanism according to claim 12, wherein the voltage generation module comprises: a control sub-module and a voltage sub-module; and
the control sub-module is used for acquiring the characteristic signal of the battery, and controlling, according to the characteristic signal of the battery, the voltage sub-module to establish the voltage difference between the safety member and the battery.

14. The safety control mechanism according to claim 13, wherein the voltage generation module further comprises: a monitoring sub-module; and
the monitoring sub-module is used for monitoring the characteristic signal of the battery and sending the characteristic signal of the battery to the control sub-module.

15. The safety control mechanism according to claim 13 or 14, wherein the voltage sub-module comprises: a voltage generator and an on-off structure, the voltage generator being connected to the safety member through the on-off structure; and
the control sub-module is used for controlling, according to the characteristic signal of the battery, the on-off structure to be turned on, so as to cause the voltage generator to establish the voltage difference between the safety member and the battery.

16. The safety control mechanism according to claim 15, wherein the voltage generator comprises: a second battery cell in the battery.

17. The safety control mechanism according to any one of claims 12 to 16, wherein the characteristic signal of the battery is used for indicating that the battery is in a thermal runaway state and/or in a critical state within a preset time period before the thermal runaway state.

18. The safety control mechanism according to any one of claims 12 to 17, wherein the characteristic signal of the battery comprises at least one of the following signals: electrical parameter, temperature, pressure, characteristic gas, or stress.

19. The safety control mechanism according to any one of claims 12 to 18, wherein the characteristic signal of the battery comprises: a characteristic signal of the first battery cell in the battery; and
the voltage generation module is used for establishing, according to the characteristic signal of the first battery cell, the voltage difference between the safety member and the first battery cell.

20. A safety control method, used for performing safety control on a battery, wherein the safety control method comprises:
establishing a voltage difference between a safety member and the battery, and when the battery is abnormal, the voltage difference causing the safety member to perform safety control.

21. The safety control method according to claim 20, wherein the safety member accommodates a safety substance; and
the voltage difference causing the safety member to perform safety control comprises:
the voltage difference being used for forming an arc between the safety member and the battery to break down the safety member, so that the safety member releases the safety substance for performing safety control.

22. The safety control method according to claim 21, wherein the battery comprises a first battery cell; and
the when the battery is abnormal, the voltage difference causing the safety member to perform safety control comprises:
when the first battery cell is abnormal, the voltage difference causing the safety member to perform safety control.

23. The safety control method according to claim 22, wherein the establishing a voltage difference between the safety member and the battery comprises:
establishing the voltage difference between the safety member and the first battery cell; and
the voltage difference being used for forming an arc between the safety member and the battery to break down the safety member, so that the safety member releases the safety substance for performing safety control comprises:
the voltage difference being used for forming an arc between the safety member and the first battery cell to break down the safety member, so that the safety member releases the safety substance for performing safety control on the space where the first battery cell is located and/or the space near the first battery cell.

24. The safety control method according to claim 23, wherein the voltage difference being used for forming an arc between the safety member and the first battery cell to break down the safety member, so that the safety member releases the safety substance for performing safety control on the space where the first battery cell is located comprises:
the voltage difference being used for forming the arc between the safety member and the first battery cell to break down the safety member and a case of the first battery cell, so that the safety member releases the safety substance to perform safety control on the internal space of the first battery cell.

25. The safety control method according to claim 23 or 24, wherein the voltage difference is related to at least one of the following parameters:
the wall thickness of the safety member, the distance between the safety member and the first battery cell, and the corresponding area between the safety member and the first battery cell.

26. The safety control method according to claim 25, wherein the voltage difference and the wall thickness of the safety member meet the following relationship: 1≤U/T≤5000, wherein U is the voltage difference in V, and T is the wall thickness of the safety member in mm; and/or,
the voltage difference and the distance between the safety member and the first battery cell meet the following relationship: U/d≥2, wherein U is the voltage difference in V, and d is the distance between the safety member and the first battery cell in mm; and/or,
the voltage difference and the corresponding area between the safety member and the first battery cell meet the following relationship: U/S≥0.00008, wherein U is the voltage difference in V, and S is the corresponding area between the safety member and the first battery cell in mm².

27. The safety control method according to any one of claims 20 to 26, wherein the voltage difference ranges from 4 V to 1000 V.

28. The safety control method according to any one of claims 22 to 27, wherein the first battery cell and the safety member are insulated from each other; and
the when the first battery cell is abnormal, the voltage difference causing the safety member to perform safety control comprises:
when the first battery cell is abnormal, the insulation between the first battery cell and the safety member failing, and the voltage difference between the first battery cell and the safety member causing the safety member to perform safety control.

29. The safety control method according to claim 28, wherein when the first battery cell is abnormal, a state of an insulation layer between the first battery cell and the safety member changes, so that the insulation between the first battery cell and the safety member fails.

30. The safety control method according to any one of claims 22 to 29, wherein the safety member is arranged corresponding to the first battery cell.

31. The safety control method according to any one of claims 20 to 30, wherein the establishing a voltage difference between the safety member and the battery comprises:
acquiring a characteristic signal of the battery, and the characteristic signal of the battery being used for indicating that the battery is abnormal; and
establishing the voltage difference between the safety member and the battery according to the characteristic signal of the battery.

32. The safety control method according to claim 31, wherein the safety control method is applied to a voltage generation module, and the voltage generation module comprises: a control sub-module and a voltage sub-module;
wherein the acquiring the characteristic signal of the battery comprises:
acquiring, by the control sub-module, the characteristic signal of the battery; and
the establishing the voltage difference between the safety member and the battery according to the characteristic signal of the battery comprises:
controlling, by the control sub-module according to the characteristic signal of the battery, the voltage sub-module to establish the voltage difference between the safety member and the battery.

33. The safety control method according to claim 32, wherein the voltage generation module further comprises: a monitoring sub-module; and the safety control method further comprises:
monitoring, by the monitoring sub-module, the characteristic signal of the battery and sending the characteristic signal of the battery to the control sub-module.

34. The safety control method according to claim 32 or 33, wherein the voltage sub-module comprises: a voltage generator and an on-off structure, the voltage generator being connected to the safety member through the on-off structure; and
wherein the controlling, by the control sub-module according to the characteristic signal of the battery, the voltage sub-module to establish the voltage difference between the safety member and the battery comprises:
controlling, by the control sub-module according to the characteristic signal of the battery, the on-off structure to be turned on, so as to cause the voltage generator to establish the voltage difference between the safety member and the battery.

35. The safety control method according to claim 34, wherein the voltage generator comprises: a second battery cell in the battery.

36. The safety control method according to any one of claims 31 to 35, wherein the characteristic signal of the battery is used for indicating that the battery is in a thermal runaway state and/or in a critical state within a preset time period before the thermal runaway state.

37. The safety control method according to any one of claims 31 to 36, wherein the characteristic signal of the battery comprises at least one of the following signals: electrical parameter, temperature, pressure, characteristic gas, or stress.

38. The safety control method according to any one of claims 31 to 37, wherein the characteristic signal of the battery comprises: a characteristic signal of the first battery cell in the battery; and
wherein the acquiring the characteristic signal of the battery comprises:
acquiring the characteristic signal of the first battery cell; and
the establishing the voltage difference between the safety member and the battery according to the characteristic signal of the battery comprises:
establishing the voltage difference between the safety member and the first battery cell according to the characteristic signal of the first battery cell.

39. A battery system, comprising:
a battery; and
the safety control mechanism according to any one of claims 1 to 19, wherein the safety control mechanism is used for performing safety control on the battery.

40. An electrical apparatus, comprising:
the battery system according to claim 39, wherein the battery system is used for providing electric energy for the electrical apparatus.
